# EUROPEAN PATENT SPECIFICATION

(11) **EP 2 153 474 B1**
(45) Date of publication and mention of the grant of the patent: **30.03.2011**
(21) Application number: 07729568.1
(22) Date of filing: 28.05.2007
(51) Int. Cl.: H01L 31/052, H01L 31/0232

(54) **Photovoltaic device with enhanced light harvesting**
Fotovoltaikvorrichtung mit verbesserter Lichtsammlung
Appareil photovoltaïque à collecte de lumière améliorée

(43) Date of publication of application: 17.02.2010
(73) Proprietor: Consiglio Nazionale delle Ricerche, 00185 Roma (IT)
(72) Inventor: TORMEN, Massimo, I-34129 Trieste (IT); INGANAS, Olle, S-582 46 Linköping (SE); TVINGSTEDT, Kristofer, S-58214 Linköping (SE); DAL ZILIO, Simone, I-34121 Trieste (IT)
(74) Representative: Rambelli, Paolo
(86) International application number: PCT/EP2007/055145
(87) International publication number: WO 2008/145176

(56) References cited:
- EP-A- 0 848 432
- JP-A- 2003 101 059
- US-A- 5 216 543
- US-A1- 2003 213 514
- US-B1- 6 515 217

## Description

### Field of the invention

The invention generally relates to thin-film solar cells and methods of enhancing the optical absorption in such devices.

More specifically, the invention is related to photovoltaic devices, with a micro-structured design such that the optical absorption and hence the efficiency in thin film photovoltaic devices with otherwise limited absorption is enhanced by confining light with a geometry exploiting micro-lens, optical spacers and mirrors. Furthermore a method for generating such structures in a straightforward and cheap way via lithographic self-alignment procedure is disclosed. The present invention also relates to a low cost fabrication process for making the photovoltaic devices of the invention.

### Background of the invention

The direct conversion of radiant energy from the sun into electrical energy on earth has for long been one of the most desirable applications for clean energy generation. As global warming seems to increase, and CO₂ pollutants appears to a large part be responsible for this, the demands for non fossil burning alternative ways to generate electricity is highly required. Photovoltaic (PV) cells are well suited for this purpose. The generation of electrons upon light absorption has been well exploited from semi-conducting materials since 1950's when the first efficient photovoltaic cell was built. Since then, several breakthroughs have generated new and improved devices with good performance. The best cells of today are exploited as power generators in satellite applications and reach power conversion efficiencies well above 25%. A main reason why existing efficient cells of today are not providing a large fraction of the earth electricity is simply the high cost of manufacturing. Although the cost has dropped lately, the costs are still too high to compete with other sources of power generation. Other newer materials and photovoltaic systems are also currently being studied and developed. One potential alternative to the expensive cells of today are thin film photovoltaic cells and in particular organic photovoltaic cells. In thin film cells a very small amount of semi-conducting material is generally used. The efficiency of non-crystalline thin film photovoltaic films is to a large extent limited by lower charge carrier mobility compared to their crystalline counterpart.

In an absorbing medium the intensity decreases exponentially as the photon flux progresses through the medium. A larger part of the impinging light is absorbed if a greater thickness of absorbing media is utilised. For some of the new photovoltaic materials, too thick layers can however not be utilised due to too low charge carrier mobility. The low charge carrier mobility will generally prevent a large part of the generated charge carriers from reaching the current extracting electrodes. In this case it is crucial to exploit some sort of absorption enhancement mechanism.

Generally, the efficiency of solar cells and the current generation per amount of active material can be increased by controlling the flow of light. By maximising the absorption one may enhance the external quantum efficiency as well as the overall power conversion efficiency of the cell. Low absorption coefficient materials such as indirect band gap Si are today depending on some sort of light trapping structures to be efficient. A first reason for exploiting light harvesting in solar cells is, as already stated, that the volume of active semi-conducting materials can be decreased. Since most semi-conducting materials are quite expensive this is generally of importance. A second reason is that photovoltaic cells generally perform with higher efficiency under higher photon flux or when exposed to photons with longer optical path lengths. By increasing the incident photon flux onto the active material by a certain amount X, the amount of charge carrier generation, and hence the current (*J*)*,* is generally enhanced by the same amount.

Furthermore, the open circuit voltage *V_{OC}* usually increase logarithmically with *X*. This accordingly gives that the power conversion efficiency increases faster than *X* if the fill factor is unaffected. By also increasing the optical path length inside the cell by making light travel more parallel to the active layer film rather than just perpendicular to it, one will increase the probability of charge carrier generation per each incident photon. This in turn also generates more current out. Increasing the photon flux, optical path length and photon absorption probability can all be done by incorporating mirrors, lenses or scattering structures on top or on the bottom of the active solar cell material.

By confining light via concentrators or path length enhancement systems the lower mobility thin films will absorb as much light as a significantly thicker one, thereby enabling charge carrier collection at the electrodes. By reflecting light multiple times through the thin film of photovoltaic material the optical path length can be increased significantly. This is facilitated by the enclosed invention.

### Prior art

Enhanced incoupling of light can be obtained via the use of diffractive gratings incorporated in the active layer or in electrodes (L. S. Roman, O. Inganas, T. Granlund et al., "Trapping light in polymer photodiodes with soft embossed gratings," Adv Mater **12** (3), 189-+ (2000).) These are however most suitable for narrow wavelength intervals, are polarisation selective, and not suitable for obtaining higher optical power incoupling from a wide spectrum light source. Rather than diffractive optics structures, designs using geometrical optics can make sure that the incoupling mechanism is operational for a major part of the relevant spectrum of the light source, and has been demonstrated by R Winston, "Principles of solar concentrators of a novel design," Solar Energy **16**, 89 (1974).

It is also demonstrated how light trapping using Winston cavities may be used to enhance power generation in thin film solar cells. These devices use normally impinging light to a surface which is covered with cavities with metallic reflectors, in a geometry which will direct light to be injected into the thin film absorber at different angles from the normal. This technological solution requires fabrication of many small cavities, open on both sides, and has been demonstrated with micro-patterning methods (P. Peumans, V. Bulovic, and S. R. Forrest, "Efficient photon harvesting at high optical intensities in ultrathin organic double-heterostructure photovoltaic diodes," Appl Phys Lett 76 (19), 2650-2652 (2000).

However, two drawbacks are present in the approach based on the fabrication of reflective Winston cavities. The angular acceptance of the light is small. Light paths with large angles are rejected after multiple reflections, reducing considerably the diffuse light harvested by the device. Secondly, the accurate lithographic definition of paraboloids opened at the bottom (i.e. below the level of the focus) is required for the optimal collection of the direct light through the bottom opening represents a challenge for fabrication.

Moreover, the paraboloids should cover as much area as possible of the visible surface in order to avoid unnecessary rejection of light. This sets even more stringent requirements on the fabrication.

Light trapping may also be performed by using rough surfaces for depositing both active materials and electrodes. Rough surfaces are difficult to combine with thin film organic solar cells, where the active layer is typically ca 100 nm, while in inorganic materials the thickness is often 10 times larger.

EP-A-1 427 025 describes a photovoltaic device comprising a first electrode arranged on a first surface of the photovoltaic conversion layer and a second electrode comprising conductive tracks arranged on the opposite second surface of the photovoltaic conversion layer. The device includes a light concentrator made of a transparent support having on its surface an array of light concentrating units, employing combinations of refractive, reflective and diffractive units.

JP 2003 101059 A describes a photovoltaic device according to the preamble of claim 1.

The present invention provides a photovoltaic device and a method for its manufacture which has improved performance and which allows to exploit independently direct light and diffuse light.

The subject matter of the invention is defined by the appended claims.

The dependent claims define further additional and preferable features of the invention and are to be construed as a part of the present disclosure.

### Brief description of drawings

In the enclosed drawings, which are provided by way of non-limiting examples:
- figure 1 is a schematic drawing of a light harvesting optical system, used in the photovoltaic device according to the invention;
- figure 1A displays the ray path of direct sunlight in the optical system of figure 1;
- figure 2 is a schematic drawing, showing the optical system of figure 1 associated with a cavity with light reflecting walls and absorbers;
- figure 2A displays the ray path of direct sunlight in the optical system of figure 2, wherein the light is absorbed directly or after a single or multiple reflection inside the cavity;
- figure 3 is a schematic drawing, showing the optical system of figure 1 combined with a photovoltaic cell that exploits direct sunlight (refer to as a first photovoltaic system); the photovoltaic cell, in this drawing, is put physically separated from the optical system for light harvesting;
- figure 3A displays possible ray paths of direct sunlight in such a system;
- figure 4 is a schematic drawing according to figure 3, wherein the photovoltaic system is put physically and optically in contact with the optical system for light harvesting;
- figure 4A displays possible ray paths of direct sunlight in the system of figure 4;
- figure 5 shows a scheme of the photovoltaic device according to the invention; and
- figure 5A display possible ray paths of both direct and diffuse sunlight in the system of figure 5, and
- figure 6 and figure 7 show a scheme of the photovoltaic device of the invention according to examples 3 and 4 which follow.

### Detailed description of the invention

The present invention makes use of a light harvesting optical system which separates direct sunlight and diffuse light.

The idea for such a system of light harvesting has been originated by the question: "Is it possible to find a sheet of material that is transparent if illuminated from one side, and reflective if illuminated from the opposite?". As the equations of the electromagnetic field are time reversible, a photon that proceeds in one direction is adsorbed by the sheet with the same probability of the photon that proceeds in the opposite direction. Therefore the answer to the above question would be negative.

However, if not considering only single photon paths, whose trajectory are reversible, but a distribution of photon paths it is possible to see that there are ways to design an optical device that allows collimated beams to pass easily through a sheet from one side and not from the other side.

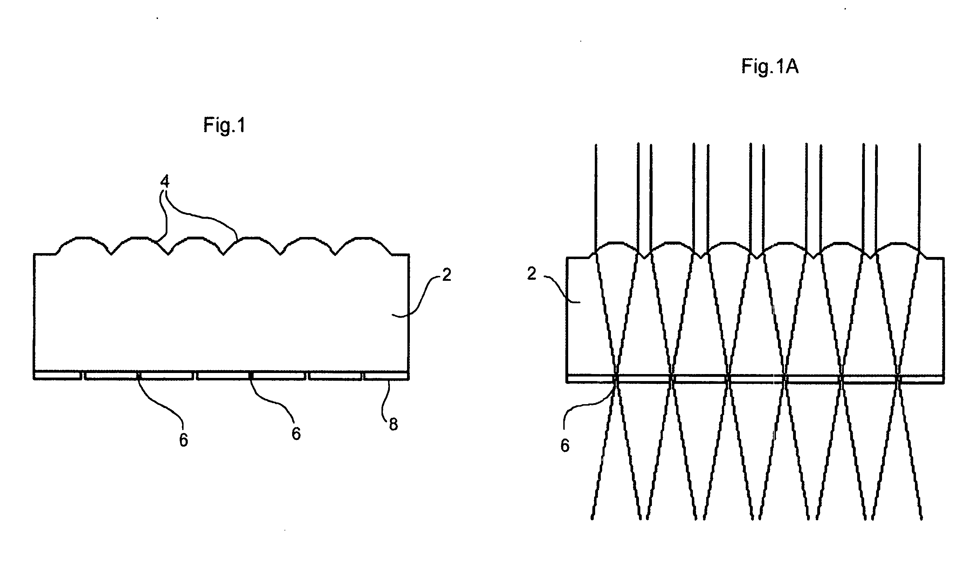

The concept of the optical device that realise this function is depicted in fig. 1. A collimated beam of photons (such as the direct sunlight) impinges on a sheet 2 with an array of micro-lenses 4 formed in a transparent dielectric material that focus the collimated light on the opposite side of said dielectric where a metal reflective film 8 is located, having an array of holes or openings 6. This hence acts as a system of pupils allowing the focused light to emerge from the other side of the sheet. The fraction of the surface area of the holes 6 in the reflective metal film 8 can be made very small with respect to the total area of the metal surface. For example, the pupils could have a diameter of 10 µm and the period could be 100 µm. A collimated light beam coming from the other side of the metal film 8 would hence mostly be reflected on the mirror (in the above example approximately 99% of the light would be reflected). Also the light of a source with random spatial and directional emission impinging on the array of pupils would be statistically reflected at the 99%, and only beams with a special and well defined spatial and directional distribution would be mostly transmitted.

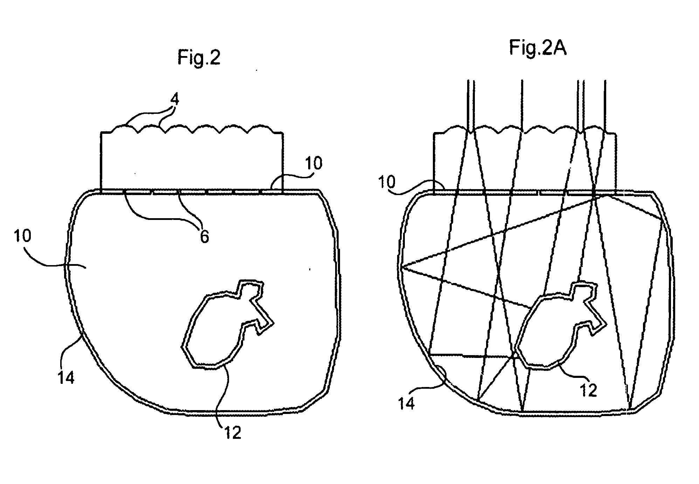

This concept exploits the well defined directionality of direct sunlight making it possible to inject light into a cavity 10 with reflective walls 14 through an optical system with the structure of figs. 2 and 2A, with a low probability that, as a result of internal reflections in the cavity, the photons emerge from it. In particular, in the presence of an absorbing material (absorber 12) in the cavity, the photon probability for being re-emitted could be made very low compared to the probability of being absorbed.

The optical device hereinbefore described can be regarded also as a directional filter that separates direct (collimated) and diffuse light. By construction, diffuse light remains outside of the cavity and is convoyed to areas where it can be exploited by a photovoltaic system in a double-pass photon absorption path. This gives the opportunity for an independent optimisation of the two photovoltaic systems (mainly the semiconductor band-gap) in order to match the different spectral composition of the direct and diffuse light. In particular, since the spectrum of diffuse light is generally blue-shifted with respect to that of direct light, it could be convenient to have the maximum absorption in the photovoltaic cell exploiting diffuse light at higher photon energy than in the photovoltaic cell exploiting direct light.

The fabrication of the light harvesting system involves the realisation of the transparent sheet 2 with the array of micro-lenses 4 on one side. This structure can be produced effectively (but not necessarily) with patterning methods based on the use of moulds or stamps, such as injection moulding, embossing, thermal or UV-based nanoimprint lithography, continuous printing with rollers etc..

The transparent sheet 2 is made of a dielectric material such as a thermoplastic polymer or a curable polymer, e.g. a UV curable sol-gel glass, preferably put on a rigid support, e.g. glass.

In order to maximise the direct sunlight harvesting it is crucial that the available surface on the transparent sheet 2 is covered entirely by the micro-lenses 4, which are preferably spherical or cylindrical lenses. A fabrication technique that satisfies this requirement has been developed by M. Tormen et al. (cf WO 2006/087744). The use of this technique has enabled the fabrication of stamps for arrays of densely packed micro-lenses covering up to 100% of the available surface, by optical or electron beam lithography and wet etching. The technique also allows a high throughput production process for large area stamps (>20x20 cm²) with spherical or cylindrical micro-lenses with accurate control of geometrical parameters.

Said micro-lenses are preferably ordered in a close packed hexagonal or square array.

The surface of the micro-lenses is preferably endowed with anti-reflective properties which can be achieved by means of surface roughness, by means of an anti-reflective surface coating, or by nanostructures.

The fabrication of the system for light harvesting according to the concept described above requires the fabrication of an array of pupils, aligned with the array of lenses 4. This step is greatly simplifed by a procedure of self-alignment proposed here, that is also object of the present patent. For the definition of the aligned pupils it is possible to exploit the micro-lenses array 4 itself to focus the radiation of a light source (IR, visible or UV) onto an array of spots (or lines in the case of cylindrical lenses) on the opposite side of the sheet. The physical definition of the location of individual pupils involves the exposure with the light focused by the micro-lenses 4 of a film of photosensitive material (such as a photoresist) deposited on the side opposite to micro-lenses array 4, followed by development of the photosensitive material. The patterning of the metal firm 8 according to the pattern in: the photosensitive material (photoresist) is obtained by pattern transfer methods, well known to operators in the micro-fabrication field, such as wet or dry etching, lift-off, electroless- or electro-plating, etc..

Prerequisite for the application of this alignment method, as well as for the correct device operation as directional light filter, is that the index of refraction of the transparent medium (or of the stack of media) of which the micro-lenses 4 and the sheet 2 are made, the radius of curvature of the micro-lenses 4 and the thickness of the sheet 2 are adjusted in order that the focal plane of the micro-lenses 4 for paraxial rays in a spectral band of interest (typically the visible to the near infrared light) coincides approximately to the plane of the opposite side of the sheet 2.

A slight detuning of the focal depth with respect to the plane P of the sheet 2 during the self-alignment procedure, would not be necessarily detrimental for the final device. On the contrary, the defocusing offers the possibility of enlarging the size of the exposed area of the photoresist, and consequently that of the pupils, in order to relax slightly the directional filtering properties and compensate for the chromatic aberration of the lenses.

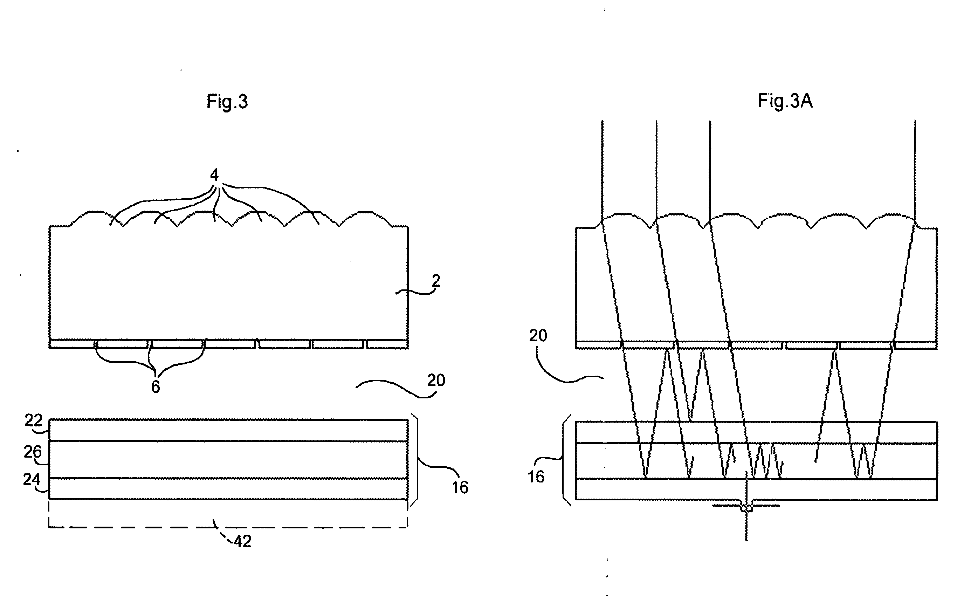

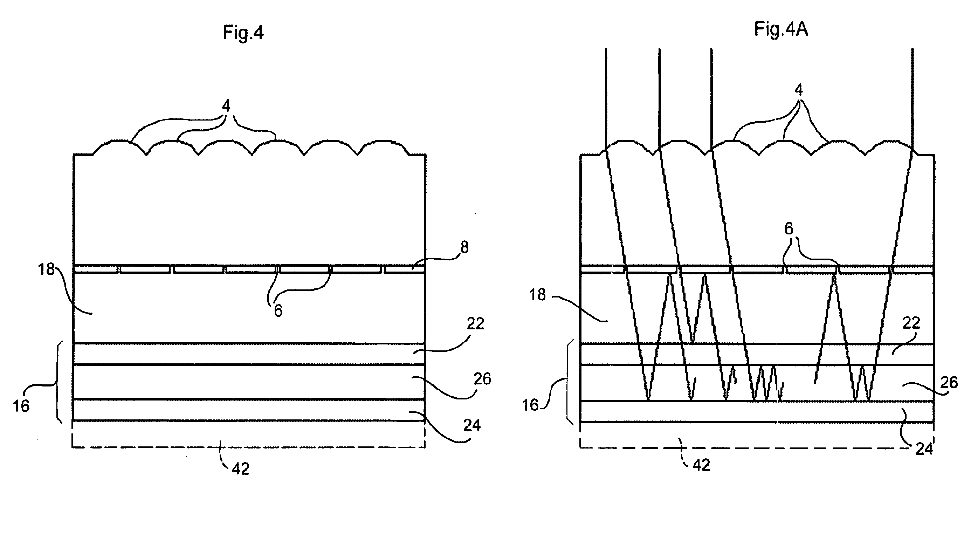

The photovoltaic device according to the invention comprises a first photovoltaic cell system for the exploitation of direct sunlight, indicated 16 in its entirety, which is located in the opposite hemi-space of the micro-lenses array 4 with respect to the plane of the openings array 6 (figs. 3, 3A, 4,4A).

The first photovoltaic cell system 16 may be connected by a layer 18 (figs. 4, 4A) of a transparent dielectric material to the assembly of micro-lenses array 4 and openings array 6, or - alternatively - is separated therefrom by an air or vacuum gap 20 (figs. 3, 3 A). The first photovoltaic cell system 16 comprises, as it is known per se, a first 22 and a second (back) 24 electrode with a conversion layer 26 therebetween (figs. 4, 4A), i.e. an active photovoltaic layer.

In one embodiment, said first photovoltaic cell system 16 has a back electrode 24 which is reflective. Alternatively, the back electrode 24 may be transparent; in this case the transparent electrode 24 acts as an optical spacer that separates the conversion layer 26 from an additional reflective layer 42 which may be simply flat or contain two-dimensional or three-dimensional scattering structures, in order to enhance the path length of back-reflected light. Furthermore, the reflective layer 42 can be used to reduce the sheet resistance of the transparent electrode 24, improving the carrier collection of the photovoltaic device.

In one embodiment the first photovoltaic system (16) can be replaced at the end of the cell lifetime.

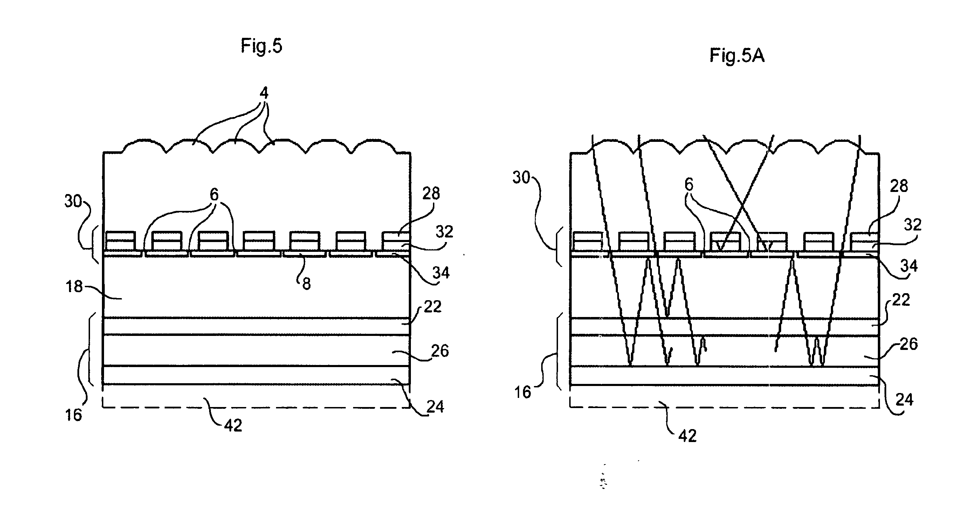

According to a characterising feature of the invention, the photovoltaic device further comprises a second photovoltaic cell system (figs. 5, 5A), indicated in its entirety with reference numeral 30, for the exploitation of diffuse light, which is located in the same hemi-space containing the micro-lenses array 4 with respect to the openings arrays 6. Said second photovoltaic system comprises a first electrode 28, one or more conversion layers 32 and a second (back) electrode 34.

The present invention is not limited to a specific material for the construction of the conversion layers 26 and 32 of the above described first 16 and second 30 photovoltaic cell systems and any suitable material may be used, provided that it is adapted to convert incident light into electrical energy and to channel it to the electrodes. Organic conversion layers are generally preferred.

In one embodiment, the metal film 8 including said openings array 6 represents an electrode (cathode or anode) for the first photovoltaic cell system 16 exploiting direct sunlight (e.g the first electrode 22) or for the second cell system 30 exploiting diffuse light (e.g. the back electrode 34) or common to both photovoltaic cell systems, as disclosed here below.

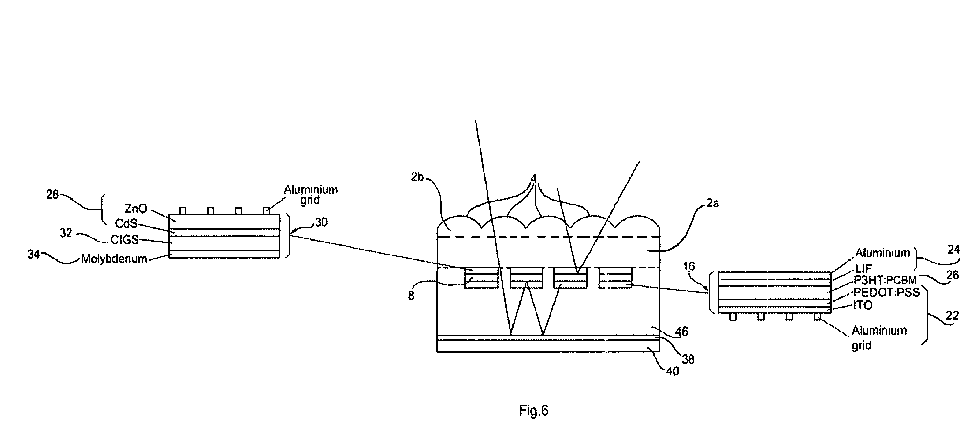

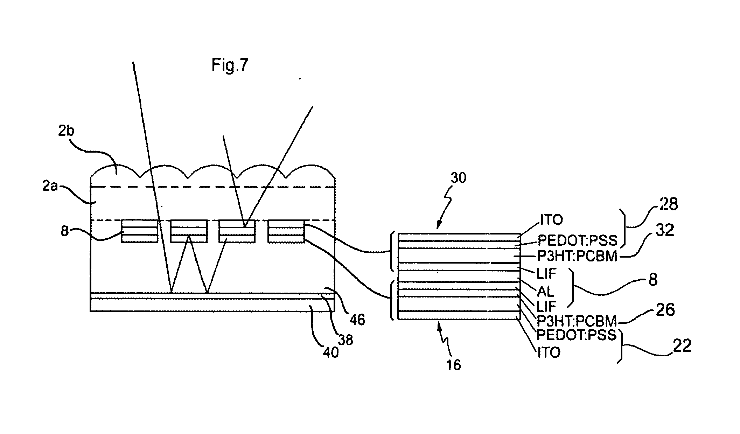

In the embodiments of figs. 6 and 7, the photovoltaic device of the invention includes the first 16 and the second 30 photovoltaic cell systems in series; the only difference with respect to the general concept of a tandem photovoltaic cell is that, in the present case, the first 16 and second 30 cell systems are separated by the metal film 8, e.g. a layer of aluminum or silver, including an array of openings 6, instead of one or more transparent layer (transparent layer 18 of figs. 4, 4A).

The device is sealed with a transparent polymeric material 46 in which the photovoltaic cells are embedded.

A reflective metal layer 38 (back-reflector) is deposited on said transparent polymeric material 46 and a protective layer 40 seals the device on its rear surface, opposite the micro-lenses array 4.

Two-dimensional or three-dimensional scattering structures may be introduced in the polymeric material 46 and/or metal back-reflector 38 for enhancing the optical path of light and optimize its absorption within the conversion layers 26 of the cell systems 16 for direct light.

The actual process of fabrication of the entire photovoltaic device may vary considerably from one realisation to another in terms of size, shape and arrangement of the lenses, materials employed, process steps and cell structure, without departing from the basic concept of concentrators exposed here.

### Example 1 (figs. 4, 4A)

The sheet of thermoplastic polymer 2 with approximately 1.5 refractive index and thickness 200 micrometer is hot embossed with a quartz or glass stamp carrying on its surface an hexagonal array of hemispherical cavities (the micro-lenses array 4) with a radius of curvature and centre-to-centre distance of 65 and 100 micrometers, respectively.

The metal film 8 of approx. 50 nm of aluminium is deposited on the flat side of the plastic sheet. A thin film of a positive tone UV photoresist is deposited on top of the aluminium layer. The micro-lens array 4 is illuminated with a collimated UV source in order to expose an array of dots in the photoresist through the metal layer 8.

The reduction to few % of the transmission of the UV light through the metal film 8 is compensated by the strong intensity enhancement of the UV light due to the focusing. This allows the exposure of the photoresist without need of increasing substantially the exposure time. After the development of the photoresist the unprotected areas of the metal film 8 are etched by wet etching and the photoresist is dissolved. The light harvesting system (i.e. the thermoplastic sheed 2 with the micro-lenses 4 on one side and pupils on the other), is bonded to the photovoltaic cell system 16 by curing the transparent dielectric material 18 that fills a gap of more than 50 micrometers.

### Example 2 (figs. 5, 5A)

A UV curable polymer is patterned with the array of micro-lenses 4 on one side of a glass substrate by UV-nanoimprint lithography. On the other side of the glass substrate a sequence of layers is deposited, in order to form the structure of the photovoltaic cell 30. For example, the stack comprises the first electrode 28 made of a conductive transparent layer such as Indium Tin Oxide (ITO) followed by PEDOT:PSS (100-300nm) (poly (3,4 - ethylenedioxythiophene):polystyrene-sulphonate), the conversion layer 32, e.g. poly(3-hexylthiophene):[6,6]-phenyl-C61-butyric acid methyl ester (P3HT:PCBM) or the belayer CdS/CdTe with a thickness in the range 50 to 300 nm, the back electrode 34 made of a of aluminium (80-120 nm).

A high sensitivity positive photoresist is deposited on the stack of layers, and exposed by the UV light focused by the array of micro-lenses 4 and partially transmitted by the stack of layers of the photovoltaic cell system 30.

After development of the photoresist the stack of layers is plasma etched in the areas from which photoresist has been removed until reaching the glass substrate. A second plasma process is used to strip the photoresist from the entire surface, stopping the process when the conductive transparent layer is reached. A cell 16, whose structure is not specified in this example, can be simply mounted in front of the aluminium layer 34 separated by a air gap (according to fig. 3) or connected by a transparent dielectric layer 18 such as PDMS, or a thermally or UV curable polymer (as in fig. 4)

### Example 3 (fig. 6)

A sequence of thin layers is deposited on glass 2a in order to obtain a stack of two photovoltaic cells. After deposition of the stack of layers (and patterning for contacts), an array of cylindrical lenses 4 is fabricated in a UV curable Sol-Gel material 2b on the opposite side of the glass substrate 2a . The Sol-Gel material 2b is selected in such a way that the hardened material has a refractive index matching that of glass 2a, thus minimizing reflection at the glass/Sol-Gel interface. Using a top to bottom alignment procedure, openings corresponding to the focus of the cylindrical lenses are realized lithographically in the entire stack of deposited layers providing an entry path for direct sunlight. The trenches in the stack of layers are filled with a thick Sol-Gel transparent coating, which is the transparent polymeric material 46, matching the refraction index of the glass substrate 2a. Finally, the reflecting metal layer 38 and the protective layer 40 are deposited on the Sol-Gel coating 46 of the rear surface.

More specifically, the cell of this example can be realized with the following materials.

The first cell system 16 (for direct light) is a organic type photovoltaic cell, whose structure comprises the back electrode 24 made of a layer of aluminium and a ultrathin (∼1 nm) lithium fluoride (LiF), the conversion layer 26 of poly(3-hexylthiophene):[6,6]-phenyl-C61-butyric acid methyl ester (P3HT:PCBM), the first electrode 22 made of a conductive transparent layer of PEDOT:PSS (100-300 nm) followed by Indium Tin Oxide(ITO).

The second cell system 30 (for diffuse light) is a CIGS (Cu, In, Ga, and Se) type cell, whose structure comprises the first electrode 28 consisting of an aluminium grid, a layer of zinc oxide followed by a layer of cadmium sulphite, the conversion layer 32 made of a cupper indium gallium selenite (CIGS), acting as absorbing layer, and the back electrode 34 made of molybdenum.

The reflective layer that separates the two photovoltaic cells in series is the layer of aluminium or silver 8.

### Example 4 (fig.7)

An array of lenses is fabricated in a UV curable Sol-Gel material 2b on one side of a glass substrate 2a. The focal length is chosen in order to have the focus of the visible light on the other side of the glass substrate 2a. The Sol-Gel material 2b is selected in such a way that the hardened material has a refractive index matching that of glass 2a, thus minimizing reflection at the glass/Sol-Gel interface.

A photovoltaic system consisting of a stack of two organic cell is obtained on the free side of the glass substrate 2a by deposition through stencil masks of a series of layers arranged symmetrically with respect to a common LiF/aluminium/LiF cathode.

More specifically, the device consists of the following sequence of layers:
- first electrode 28 of the second cell system 30:
   - Indium tin oxide
   - PEDOT:PSS
- conversion layer 32 of the second cell system 30:
   - bulk heterojunction consisting of a blend of methanofullerene[6,6]-phenyl C61 butyric acid methylester (PCBM) and poly(3-hexylthiophene) (P3HT).
- layer 8, which corresponds to the back electrode 34 of the second cell system 30 and to the back electrode 24 of the first cell system 16:
   - LiF
   - Al
   - LiF
- conversion layer 26 of the first cell system 16:
   - bulk heterojunction consisting of a blend of methanofullerene[6,6]-phenyl C61 butyric acid methylester (PCBM) and poly(3-hexylthiophene) (P3HT)
- first electrode 22 of the first cell system 16:
   - PEDOT:PSS
   - Indium Tin Oxide

Different stencil masks are used in the series of deposited layers in order to form three non overlapping contact areas for the aluminium cathode and for the two Indium Tin Oxide anodes of first 16 and second 30 cell systems. Moreover, the stencil contain features that prevent the deposition of material in the regions corresponding to the focus of the lenses, in order to create the entry path for light into the hemi-space of the first cell system 16. Different thicknesses for the bulk heterojunction layer are used in the first 16 and second 30 cell systems, in order to ensure the maximum exploitation of light both for double-pass (second cell system 30) and for multiple-pass (first cell system 16) of light.

A post-production annealing can be performed at this stage in order to improve the characteristics of the cells and of the contacts. The device is contacted and sealed with the transparent polymeric material 46 followed by the deposition of the metal a back-reflector 38. The protective layer 40 seals the device and protects the back-reflector 38 from scratches. The introduction of two-dimensional or three-dimensional scattering structures in the polymeric material 46 and/or metal back-reflector 38 can be used for enhancing the optical path of light and optimize its absorption within the photoconversion layer 26 of the first cell system 16.

## Claims

1. A photovoltaic device comprising an optical system for enhanced light harvesting comprising:
- a transparent layer of dielectric material (2) having on one side an array of micro-lenses (4) and on the opposite side a metal reflective film (8) with an array of openings (6), wherein said micro-lenses (4) focus direct sunlight impinging thereon, parallel to the optical axis of said micro-lenses, through said openings (6), thereby to separate direct sunlight and diffuse sunlight; and
- a first photovoltaic cell system (16) for the exploitation of the direct sunlight located in the opposite hemi-space of the micro-lenses array (4) with respect to the plane of the openings array (6),
**characterised in that** it further comprises:
- a second photovoltaic cell system (30) for the exploitation of diffuse sunlight, located in the same hemi-space containing the micro-lenses array (4) with respect to the plane of the openings array (6).

2. A photovoltaic device according to claim 1, wherein said micro-lenses array (4) comprises spherical lenses or cylindrical lenses.

3. A photovoltaic device according to claim 2, wherein said spherical lenses are ordered in a close packed hexagonal or square array.

4. A photovoltaic device according to any of claims 1 to 3, wherein said array of openings (6) comprises transparent holes (6) or transparent lines in a film (8) of otherwise reflective material.

5. A photovoltaic device according to any of claims 1 to 4, in which said first photovoltaic cell system (16) is connected by a layer of a transparent dielectric material (18) to the assembly of micro-lenses (4) and openings array (6).

6. A photovoltaic device according to claim 5, in which said transparent dielectric material (18) comprises an elastomeric material.

7. A photovoltaic device according to any of claims 1 to 6, wherein said first photovoltaic cell system (16) exploiting direct light is separated by an air or vacuum gap (20) from the assembly of micro-lenses (4) and openings array (6).

8. A photovoltaic device according to any of claims I to 7, wherein said metal reflective film (8) comprises an electrode for said first photovoltaic cell system (16) exploiting direct light or for said second cell system (30) exploiting diffuse light or for said both photovoltaic cell systems.

9. A photovoltaic device according to any of claims 1 to 8, wherein said first photovoltaic cell system (16) has a transparent back electrode (24) or a reflective back electrode (24), which reflective back electrode is optionally patterned with two-dimensional or three-dimensional scattering structures in order to deflect light rays and further increase the optical path in the absorbing layer of the photovoltaic cell (16).

10. A photovoltaic device according to claim 9, wherein said transparent back electrode (24) is separated via a second optical spacer from a reflective pattern (42) with two-dimensional or three-dimensional scattering structures in order to deflect light rays and further increase the optical path in the absorbing layer of the corresponding cell (16).

11. A photovoltaic device according to any of the preceding claims, wherein the surface of said micro-lenses (4) has a surface roughness or comprises nanostructures suitable to increase its antireflective properties.

12. A photovoltaic device according to any of claims 1 to 10, in which the surface of said micro-lenses (4) is coated with an antireflective film coating.

13. A photovoltaic device according to any of claims 1 to 12, in which the photon absorption by the first cell (16) is red-shifted with respect that of the second cell (30).

14. A photovoltaic device according to any of claims 1 to 12, in which the energy gap for the optical transitions in the active layers of both the first (16) and second (30) photovoltaic cell are in the range 0.8 to 2.5eV, and the energy gap of the active material of the second cell (30) is larger than the one of the first cell (16).

15. A method for the construction of photovoltaic device according to any of claims I to 14, comprising the steps of:
- providing a transparent layer (2) of dielectric material having on one side thereof an array of micro-lenses (4);
- applying to the opposite side of said transparent layer a film of a reflective conductive material (8);
- applying on top of said film of a reflective conductive material a film of photosensitive material;
- irradiating said array of micro-lenses (4) with a collimated light source in order to expose to said light source selected areas forming an array in said film of photosensitive material, through said reflective conductive material;
- developing the photosensitive material thereby to leave unprotected areas; and
- removing the conductive material from the unprotected areas thereby to obtain an array of openings in said conductive material.

## Patentansprüche

1. Photovoltaische Vorrichtung, umfassend ein optisches System für erhöhte Lichtsammlung, umfassend:
eine transparente Schicht aus dielektrischem Material (2), die auf einer Seite eine Anordnung von Mikrolinsen (4) und auf der gegenüberliegenden Seite einen reflektierenden Metallfilm (8) mit einer Anordnung von Öffnungen (6) aufweist, wobei die Mikrolinsen (4) parallel zu der optischen Achse der Mikrolinsen durch die Öffnungen (6) darauf treffendes direktes Sonnenlicht fokussieren, um dabei direktes Sonnenlicht von diffusem Sonnenlicht zu trennen und
ein erstes photovoltaisches Zellensystem (16), das in dem gegenüberliegenden Halbraum der Mikrolinsenanordnung (4) in Bezug zu der Ebene der Öffnungsanordnung (6) angeordnet ist, zur Nutzung des direkten Sonnenlichts,
**dadurch gekennzeichnet, dass** sie ferner umfasst:
ein zweites photovoltaisches Zellensystem (30), das in dem gleichen die Mikrolinsenanordnung (4) enthaltenden Halbraum in Bezug zu der Ebene der Öffnungsanordnung (6) angeordnet ist, zur Nutzung von diffusem Sonnenlicht.

2. Photovoltaische Vorrichtung nach Anspruch 1, wobei die Mikrolinsenanordnung (4) sphärische Linsen oder zylindrische Linsen umfasst.

3. Photovoltaische Vorrichtung nach Anspruch 2, wobei die sphärischen Linsen in einer dicht gepackten hexagonalen oder rechteckigen Anordnung geordnet sind.

4. Photovoltaische Vorrichtung nach einem der Ansprüche 1 bis 3, wobei die Anordnung von Öffnungen (6) transparente Löcher (6) oder transparente Linien in einem Film (8) aus sonst reflektierendem Material umfasst.

5. Photovoltaische Vorrichtung nach einem der Ansprüche 1 bis 4, wobei das erste photovoltaische Zellensystem (16) durch eine Schicht aus einem transparenten, dielektrischen Material (18) mit der Anordnung aus Mikrolinsen (4) und Öffnungsanordnung (6) verbunden ist.

6. Photovoltaische Vorrichtung nach Anspruch 5, wobei das transparente dielektrische Material (18) ein elastomeres Material umfasst.

7. Photovoltaische Vorrichtung nach einem der Ansprüche 1 bis 6, wobei das erste, direktes Sonnenlicht nutzende photovoltaische Zellensystem (16) von der Anordnung aus Mikrolinsen (4) und Öffnungsanordnung (6) durch einen Luft- oder Vakuumspalt (20) getrennt ist.

8. Photovoltaische Vorrichtung nach einem der Ansprüche 1 bis 7, wobei der reflektierende Metallfilm (8) eine Elektrode für das erste, direktes Sonnenlicht nutzende photovoltaische Zellensystem (16) oder für das zweite, diffuses Sonnenlicht nutzende photovoltaische Zellensystem (30) oder für beide photovoltaischen Zellensysteme umfasst.

9. Photovoltaische Vorrichtung nach einem der Ansprüche 1 bis 8, wobei das erste photovoltaische Zellensystem (16) eine transparente Rückelektrode (24) oder eine reflektierende Rückelektrode (24) aufweist, wobei in der reflektierende Rückelektrode optional zweidimensionale oder dreidimensionale Streustrukturen ausgebildet sind, um Lichtstrahlen abzulenken und die optische Weglänge in der absorbierenden Schicht der photovoltaischen Zelle (16) weiter zu erhöhen.

10. Photovoltaische Vorrichtung nach Anspruch 9, wobei die transparente Rückelektrode (24) mittels eines zweiten optischen Abstandshalters von einem reflektierenden Muster (42) mit zweidimensionalen oder dreidimensionalen Streustrukturen getrennt ist, um Lichtstrahlen abzulenken und die optische Weglänge in der absorbierenden Schicht der entsprechenden Zelle (16) weiter zu erhöhen.

11. Photovoltaische Vorrichtung nach einem der vorangehenden Ansprüche, wobei die Oberfläche der Mikrolinsen (4) eine Oberflächenrauheit aufweist oder Nanostrukturen umfasst, die dazu geeignet ist/sind, ihre antireflektierenden Eigenschaften zu verbessern.

12. Photovoltaische Vorrichtung nach einem der Ansprüche 1 bis 10, wobei die Oberfläche der Mikrolinsen (4) mit einer antireflektierenden Filmbeschichtung beschichtet ist.

13. Photovoltaische Vorrichtung nach einem der Ansprüche 1 bis 12, wobei die Photonenabsorption durch die erste Zelle (16) in Bezug zu der zweiten Zelle (30) rotverschoben ist.

14. Photovoltaische Vorrichtung nach einem der Ansprüche 1 bis 12, wobei die Energielücke für die optischen Übergänge in den aktiven Schichten sowohl der ersten (16) als auch der zweiten (30) photovoltaischen Zelle in dem Bereich von 0.8 bis 2.5 eV liegt und die Energielücke des aktiven Materials der zweiten Zelle (30) größer als die der ersten Zelle (16) ist.

15. Verfahren zur Herstellung einer photovoltaischen Vorrichtung nach einem der Ansprüche 1 bis 14, umfassend die Schritte:
Bereitstellen einer transparenten Schicht (2) aus dielektrischem Material, die auf einer Seite davon eine Anordnung von Mikrolinsen (4) aufweist;
Aufbringen eines Films aus reflektierendem, leitfähigem Material (8) auf die gegenüberliegende Seite der transparenten Schicht;
Aufbringen eines Films aus lichtempfindlichem Material auf den Film aus einem reflektierenden, leitfähigen Material;
Bestrahlen der Anordnung von Mikrolinsen (4) mit einer kollimierten Lichtquelle, um ausgewählte, eine Anordnung in dem Film aus lichtempfindlichem Material bildende Bereiche durch das reflektierende, leitfähige Material der Lichtquelle auszusetzen;
Entwickeln des lichtempfindlichen Materials, um dabei ungeschützte Bereiche zu hinterlassen; und
Entfernen des leitfähigen Materials aus den ungeschützten Bereichen, um dabei eine Anordnung von Öffnungen in dem leitfähigen Material zu erhalten.

## Revendications

1. Dispositif photovoltaïque comprenant un système optique adapté pour une récolte de lumière améliorée, le dispositif photovoltaïque comprenant :
une couche transparente de matériau diélectrique (2) comportant, sur l'un de ses côtés, une matrice de microlentilles (4) et sur le côté opposé, une couche mince métallique réfléchissante (8) munie d'une matrice d'ouvertures (6), dans lequel lesdites microlentilles (4) concentrent la lumière directe du soleil qui est projetée sur elles, parallèlement à l'axe optique desdites microlentilles, à travers lesdites ouvertures (6), de sorte à séparer la lumière directe du soleil et à diffuser la lumière du soleil ; et
un premier système de cellules photovoltaïques (16) adapté pour l'exploitation de la lumière directe du soleil, qui est placé dans l'hémi-espace opposé de la matrice de microlentilles (4) par rapport au plan de la matrice d'ouvertures (6),
**caractérisé en ce qu'**il comprend par ailleurs :
un second système de cellules photovoltaïques (30) adapté pour l'exploitation de la lumière du soleil diffuse, qui est placé dans le même hémi-espace contenant la matrice de microlentilles (4) par rapport au plan de la matrice d'ouvertures (6).

2. Dispositif photovoltaïque selon la revendication 1, dans lequel ladite matrice de microlentilles (4) comprend des lentilles sphériques ou des lentilles cylindriques.

3. Dispositif photovoltaïque selon la revendication 2, dans lequel lesdites lentilles sphériques sont agencées en une matrice hexagonale ou carrée à proximité étroite les unes des autres.

4. Dispositif photovoltaïque selon l'une quelconque des revendications 1 à 3, dans lequel ladite matrice d'ouvertures (6) comprend des trous transparents (6) ou des lignes transparentes dans une couche mince (8) d'un matériau autrement réfléchissant.

5. Dispositif photovoltaïques selon l'une quelconque des revendications 1 à 4, dans lequel ledit premier système de cellules photovoltaïques (16) est connecté par une couche d'un matériau diélectrique transparent (18) à la matrice de microlentilles (4) et à la matrice d'ouvertures (6).

6. Dispositif photovoltaïque selon la revendication 5, dans lequel ledit matériau diélectrique transparent (18) comprend un matériau élastomère.

7. Dispositif photovoltaïque selon l'une quelconque des revendications 1 à 6, dans lequel ledit premier système de cellules photovoltaïques (16) exploitant la lumière directe est séparé par un intervalle d'air ou de vide (20) de la matrice de microlentilles (4) et de la matrice d'ouvertures (6).

8. Dispositif photovoltaïque selon l'une quelconque des revendications 1 à 7, dans lequel ladite couche mince métallique réfléchissante (8) comprend une électrode pour ledit premier système de cellules photovoltaïques (16) qui exploite la lumière directe ou pour ledit second système de cellules photovoltaïques (30) qui exploite la lumière diffuse ou pour lesdits deux systèmes de cellules photovoltaïques.

9. Dispositif photovoltaïque selon l'une quelconque des revendications 1 à 8, dans lequel ledit premier système de cellules photovoltaïques (16) comprend une électrode arrière transparente (24) ou une électrode arrière réfléchissante (24), ladite électrode arrière réfléchissante étant façonnée en option avec des structures de diffusion à deux dimensions ou à trois dimensions dans le but de défléchir des rayons lumineux et d'augmenter d'autre part le chemin optique dans la couche absorbante du premier système de cellules photovoltaïques (16).

10. Dispositif photovoltaïque selon la revendication 9, dans lequel ladite électrode arrière transparente (24) est séparée, par le biais d'un second intervalle optique, d'un motif (42) réfléchissant ayant des structures de diffusion à deux dimensions ou à trois dimensions dans le but de défléchir des rayons lumineux et d'augmenter d'autre part le chemin optique dans la couche absorbante du premier système de cellules photovoltaïques (16) correspondant.

11. Dispositif photovoltaïque selon l'une quelconque des revendications précédentes, dans lequel la surface desdites microlentilles (4) a une dureté de surface ou comprend des nanostructures adaptées pour augmenter ses propriétés anti-réfléchissantes.

12. Dispositif photovoltaïque selon l'une quelconque des revendications 1 à 10, dans lequel la surface desdites microlentilles (4) est recouverte d'un revêtement fait d'une couche mince anti-réfléchissante.

13. Dispositif photovoltaïque selon l'une quelconque des revendications 1 à 12, dans lequel l'absorption de photons par le premier système de cellules photovoltaïques (16) est décalée vers le rouge par rapport à celle du second système de cellules photovoltaïque (30).

14. Dispositif photovoltaïque selon l'une quelconque des revendications 1 à 12, dans lequel l'intervalle d'énergie pour les transitions optiques dans les couches actives du premier (16) comme du second (30) systèmes de cellules photovoltaïques se situe dans la plage de 0,8 à 2,5 eV, et l'intervalle d'énergie du matériau actif du second système de cellules photovoltaïques (30) est plus grand que celui du premier système de cellules photovoltaïques (16).

15. Procédé pour la construction d'un dispositif photovoltaïque selon l'une quelconque des revendications 1 à 14, comprenant les étapes consistant :
à fournir une couche transparente (2) de matériau diélectrique comportant, sur l'un de ses côtés, une matrice de microlentilles (4) ;
à appliquer, sur le côté opposé de ladite couche transparente, une couche mince d'un matériau conducteur réfléchissant (8) ;
à appliquer, sur le dessus de ladite couche mince faite en un matériau conducteur réfléchissant, une couche mince de matériau photosensible ;
à irradier ladite matrice de microlentilles (4) avec une source de lumière collimatée dans le but d'exposer à ladite source de lumière des zones sélectionnées formant une matrice dans ladite couche mince de matériau photosensible, à travers ledit matériau conducteur réfléchissant ;
à développer le matériau photosensible de sorte à laisser des zones non protégées ; et
à éliminer le matériau conducteur des zones non protégées pour obtenir ainsi une matrice d'ouvertures dans ledit matériau conducteur.
